# EUROPEAN PATENT APPLICATION

(11) **EP 0 601 713 A1**
(43) Date of publication of application: **15.06.1994**
(21) Application number: 93308970.8
(22) Date of filing: 10.11.1993
(51) Int. Cl.: H03F 3/45, H03F 1/02

(54) **Amplifier devices**

(30) Priority: 11.12.1992 GB 9225883
(71) Applicant: GEC-MARCONI LIMITED, Stanmore, Middlesex HA7 4LY (GB)
(72) Inventor: Fluxman, Steven Michael, Harrow, Middlesex CB4 3DB (GB); Reita, Carlo, Cambridge CB4 3DB (GB)
(74) Representative: Lawrence, Brian Richard

(57) **Abstract**

A method of operating an amplifier comprising a plurality polysilicon thin film transistors (27,29,31,33,39,49,53) including a current source transistor (39) and a load transistor (27,31), the method comprising operating the current source transistor (39) and the load transistor (27,31) at a gate to source voltage less than a threshold voltage (as defined) to reduce the drain conductance of said source and load transistors ad thereby to improve amplifier performance parameters which depend on said drain conductance.

## Description

This invention relates to amplifier devices and particularly to linear amplifiers (such as operational amplifiers) comprising polysilicon thin film transistors.

Processes are known for the manufacture of polycrystalline silicon thin film transistors in which the process is carried out at relatively low temperature to avoid softening of a glass substrate on which the transistors are formed. The known devices are formed as self-aligned structures with ion-implanted source and drain regions, doped either n-type or p-type to give n-type and p-type transistors, respectively.

An integrated-circuit amplifier may be formed by providing a number of interconnected polysilicon thin film transistors.

When operated under conventional conditions, an amplifier comprising such transistors has a low gain compared with that of an operational amplifier formed from silicon MOSFET devices.

It is an object of the present invention to enable an improvement in performance to be achieved in an amplifier formed from polysilicon thin film transistors.

According to the invention there is provided a method of operating an amplifier comprising a plurality of polysilicon thin film transistors including a current source transistor and a load transistor, the method comprising operating the current source transistor and the load transistor at a gate to source voltage less than a threshold voltage (as herein defined) to reduce the drain conductance of said source and load transistors and thereby to improve amplifier performance paramaters which depend on said drain conductance.

As used herein, the term "threshold voltage" means the gate to source voltage at which the free charge density is equal to the fixed charge density in the channel region of the transistor. Below 'threshold', the fixed charge density is smaller than the free charge density, while above 'threshold' the free charge dominates.

An embodiment of the invention will now be described, by way of example, with reference to the accompanying drawings, in which
Figure 1 illustrates output current/voltage characteristics of a typical n-type polysilicon thin film transistor, at various gate to source bias voltages,
Figure 2 is a schematic circuit diagram of an operational amplifier comprising polysilicon thin film transistors,
Figure 3 shows comparative graphs of output voltage versus bias voltage for a polysilicon thin film transistor and a silicon MOSFET, and
Figure 4 shows curves of gain versus drain to source current for n-type and p-type polysilicon thin film transistors.

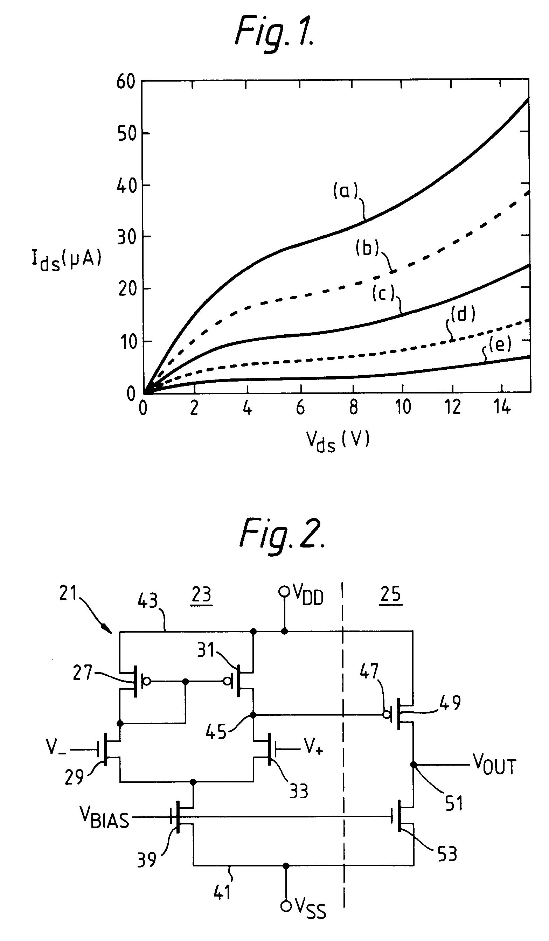

Referring to Figure 1 of the drawings, a curve (a) taken at a gate to source voltage V_{gs} of 9 volts, which is above the threshold voltage Vₜₕ (7 volts) for a particular polysilicon thin film transistor, shows that the output current/voltage (I_{ds}/V_{ds}) characteristic exhibits a pronounced kink or rapid increase in current above approximately 10 volts V_{ds}. The output conductance g_{ds} of the transistor in the saturation region at this drain to source voltage is relatively high above "threshold." This gives rise to low gain in an amplifier which includes current source and load transistors operating at such drain to source voltage V_{ds} above threshold.

Curves (b), (c), (d) and (e) taken at a gate to source voltage of 8 volts, 7 volts, 6 volts and 5 volts, respectively, exhibit progressively smaller kinks, and this reduction in the effect is taken into account in the present invention. For example, the conductance g_{ds} at V_{gs} = 5 volts is a factor of 10 smaller than that at V_{gs} = 10 volts, for V_{ds} = 10 volts.

Figure 2 is a circuit diagram of an integrated operational amplifier 21 comprising seven polysilicon thin film transistors. Each transistor may, for example, occupy an area of 400um by 15um. The amplifier 21 comprises two amplifier stages 23,25, the first stage 23 comprising n-type transistors 29,33 forming a differential amplifier and p-type transistors 27,31 forming a current mirror load which provides a single-ended output at a junction 45. Input voltages are applied to the gates of the transistors 29 and 33. The source electrodes of the transistors 29 and 33 are connected via a voltage-controlled current source transistor 39 to a source voltage supply line 41. The source electrodes of the transistors 27 and 31 are connected to a drain voltage supply line 43. An output is taken from the junction 45 of the drain electrode of the transistor 31 and the drain electrode of the transistor 33 and is fed to the gate electrode of a common source transistor 49. The amplifier output is fed out from the junction 51 of the drain electrode of the transistor 49 and the drain electrode of a current source transistor 53 connected in series with the transistor 49.

In use of the operational amplifier 21, the voltage V_{gs} applied to the transistors is maintained below the threshold voltage, thereby considerably increasing the gain, the common mode rejection ratio and the linear range of the amplifier relative to that which would be obtained if those transistors were operated under the conventional conditions where V_{gs} is above the threshold value. The "linear range" is the bias voltage range over which the amplifier operates linearly.

In conventional amplifiers based on crystalline silicon MOSFETS, the gain increases with decreasing current above 'threshold.' At 'threshold' the gain reaches its maximum and does not increase any further as the current is decreased. Furthermore, the transistors are in their off-state below 'threshold' and the amplifier no longer operates linearly.

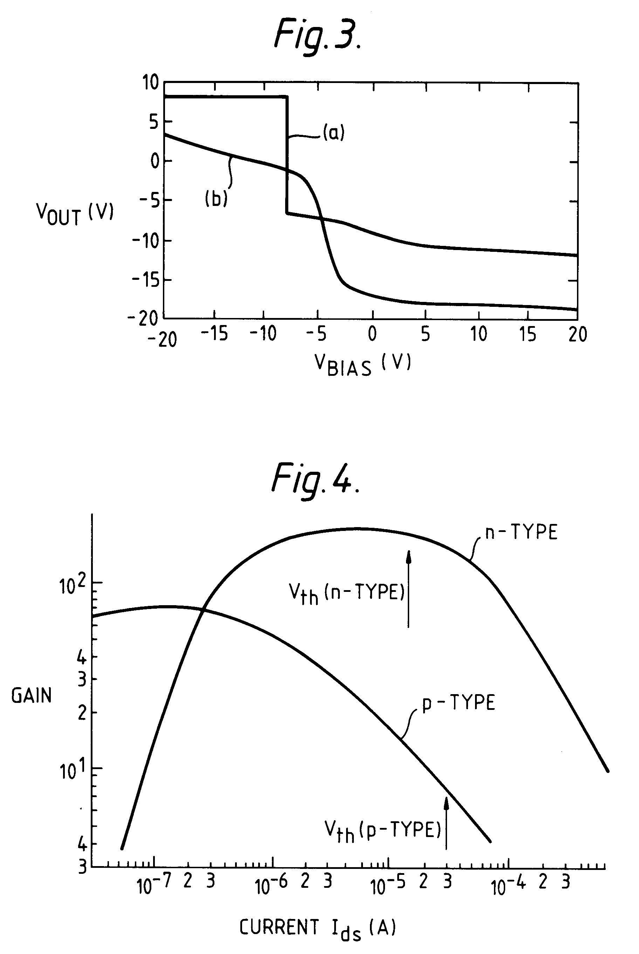

In contrast, polysilicon thin-film transistors do not switch off abruptly below threshold and there is a smooth transistion from above threshold to below threshold. Figure 3 illustrates the difference in behaviour of the d.c. output voltages, between a polysilicon thin film transistor amplifier (curve (b)) and a crystalline silicon MOSFET amplifier (curve (a)). In curve (a), the output voltage abruptly rises to the supply voltage as a result of one of the transistors switching off, whereas in curve (b) there is a smooth transition. Hence, it is possible to operate polysilicon thin film transistor amplifiers linearly below threshold.

Figure 4, which shows curves of gain versus current for single n and p type thin film transistors, confirms that the gain continues to increase with decreasing current below threshold. It should be noted that this is especially so for the p-type device which has a more pronounced kink. Operation below threshold is therefore clearly effective in increasing the gain for devices with a large kink.

By operating the transistors below the threshold voltage the current level will also be reduced, thereby reducing the power consumption of the amplifier. It should also be noted that due to low mobility, polysilicon thin film transistors draw much smaller currents, at the same voltage, than silicon MOSFETS. Although the transconductance gₘ is also much lower, the gain of polysilicon operational amplifiers will still be high because the value of g_{ds} decreases proportionally.

By operating the transistors below the threshold voltage in the manner described in accordance with the invention, the undesirable kink in the transistor characteristics is dealt with, and the operational amplifier has improved gain, common mode rejection ratio and linear range, without the need to add further complication by way of, for example, cascode devices.

The bandwidth of the amplifier will be reduced by the reduction in operating current of the transistors, and it is necessary to decide on a compromise between gain and bandwidth.

## Claims

1. A method of operating an amplifier comprising a plurality of polysilicon thin film transistors including a current source transistor and a load transistor, the method comprising operating the current source transistor and the load transistor at a gate to source voltage less than a threshold voltage (as hereinbefore defined) to reduce the drain conductance of said source and load transistors and thereby to improve amplifier performance parameters which depend on said drain conductance.

2. A method as claimed in Claim 1, wherein said performance parameters include any or all of gain, linear range and common mode rejection ratio.

3. A method as claimed in Claim 1, wherein operation of transistors at said gate to source voltage less than the threshold voltage extends the linear range of the amplifier.
